(19) Europäisches Patentamt
European Patent Office
Office européen des brevets

(11) **EP 4 465 363 A1**

(12) **EUROPEAN PATENT APPLICATION**
published in accordance with Art. 153(4) EPC

(43) Date of publication:
**20.11.2024  Bulletin 2024/47**

(51) International Patent Classification (IPC):
**H01L 29/66** (2006.01)     **H01L 29/778** (2006.01)

(21) Application number: **22919310.7**

(52) Cooperative Patent Classification (CPC):
**H01L 29/66; H01L 29/778**

(22) Date of filing: **23.12.2022**

(86) International application number:
**PCT/BR2022/050522**

(87) International publication number:
**WO 2023/133616 (20.07.2023 Gazette 2023/29)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **13.01.2022  BR 102022000629**

(71) Applicant: **Universidade Estadual Paulista
Julio de Mesquita Filho
01049-010 São Paulo (BR)**

(72) Inventors:
- **ROBERTO BUENO, Paulo
  Centro, São Paulo (BR)**
- **CRISTINE LOPES, Laís
  Centro, São paulo (BR)**

(74) Representative: **Studio Torta S.p.A.
Via Viotti, 9
10121 Torino (IT)**

(54) **PREPARATION METHOD FOR QUANTUM TRANSISTOR AND MODIFIED QUANTUM TRANSISTOR**

(57)    The invention deals with a new method for preparing a quantum transistor and a modified quantum transistor, which is an electronic device in the field of microelectronics formed by (or containing) one-dimensional or two-dimensional structures that have quantum conductance and capacitance, correlated by quantum entanglement; wherein the obtained quantum transistor works in A.C. (alternating current) mode or through transient disturbances. Thus, it becomes possible to provide all the applications already available in classical transistors that operate in D.C. (direct current) mode, but with additional advantages that include greater sensitivities and better electronic and information transport performance over long distances in the device, intrinsic properties of quantum phenomena and new transistor architectures that were previously not possible to be realized in D.C. mode, as is the case with classical transistors.

Figure 1

## Description

The present invention deals with a new method of preparing a quantum transistor and a modified quantum transistor, which is an electronic device in the field of microelectronics formed by, or containing, one-dimensional or two-dimensional structures that present conductance and quantum capacitance, correlated by quantum entanglement; wherein the quantum transistor obtained works in A.C. (alternating current) mode or through transient disturbances. Thus, it becomes possible to provide all the applications already available in classical transistors that operate in D.C. (direct current) mode, but with additional advantages that include greater sensitivities and better electronic and information transport performance over long distances in the device, intrinsic properties of quantum phenomena and new transistor architectures that were previously not possible to be realized in D.C. mode, as is the case with classical transistors.

FIELD OF APPLICATION

The method for preparing a quantum transistor and a modified quantum transistor, object of the present invention, has application in the field of microelectronics, more specifically for the preparation of microstructures with nanometric dimensions molded in one-dimensional or two-dimensional materials, which have excellent electronic, chemical, optical and magnetic properties, to be used in various applications such as: field effect transistors (FET) of different natures: metal-oxide-semiconductor FET (MOSFET) of depletion type, which can be N-channel or P-channel, and of the intensification type, which can be N-channel or P-channel, junction FET (JFET) of depletion type, which can be N-channel or P-channel, organic field effect transistor (OGFET), insulated gate bipolar transistor (IGBT), organic memory nanoparticle (NOMFET), DNA field effect transistor (DNAFET) , metal and semiconductor field effect transistor (MESFET), high electron mobility transistor (HEMT), fast recovery epitaxial diodes (FREDFET), ion sensitive field effect transistor (ISFET), chemically sensitive field effect transistor (ChemFET), graphene-based field effect transistor (GFET) .

OBJECTIVES OF THE INVENTION

The method for preparing a quantum transistor and an obtained quantum transistor, object of the present invention, aims to present a method for preparing a quantum transistor formed by one-dimensional or two-dimensional structures correlated by quantum entanglement, wherein the quantum transistor obtained works in A.C. mode (alternating current) or by transient disturbances, which allow all applications already available in classical transistors that operate in D.C. (direct current) mode for transistor architectures that were previously not possible to be realized in D.C. mode.

Another objective of the invention is to present an economically viable method of preparing a quantum transistor with better electronic transport performance in the transistor channel, providing less energy loss during the operation.

It is also the objective of this invention to present a method of preparing quantum transistors functioning as amplifiers or switches, which can be used in basic components of all electronic chips and new quantum transistor devices, as long as using A.C. modes or similar modulation of operation.

Another objective of this invention is to present a method for preparing a quantum transistor whose entanglement properties of one-dimensional (1D) or two-dimensional (2D) structures are much more sensitive and precise than what is currently available for application in health field (diagnosis of diseases, discoveries of new compounds), environment (detection of pesticides, chemical weapons, contaminants in water, ecological pollution control), and food industry (detection of bacteria, chemical and biological contaminants, quality control).

STATE OF THE ART

In research carried out in specialized databases, documents were found relating to methods for preparing quantum transistor devices, but none of these methods and microelectronic devices have the configuration and functioning characteristics as described in this invention. Among such documents, the following can be highlighted:

Patent document JPH0595106A, which provides a quantum element with good signal transmission properties. Thin-line quantum transistors are connected by a quantum line having the same size as the quantum transistor. That way, electron reflection and scattering in a part of the connection wiring can be restricted, and a good signal transmission element can be realized;

Patent document JPH01189968A, which presents two stages of doped Si functional layers forming a junction with the surface of a GaAs semiconductor substrate. An undoped GaAs layer is provided on top of the above-mentioned layers; in addition, a gate electrode is provided, high-density source and drain regions being formed on both sides of the electrode; and ohmic electrodes are provided in the top layer of these regions. Quantum interference type transistor can be formed easily. Since the doping layers can be homogeneously bonded to the semiconductor substrate to be used, the doping layers have a high degree of freedom. As a result, an ultra-high-speed quantum interference-type transistor can be formed easily; and

Patent document EP3073728A1, which presents a graphene quantum dot field effect transistor configured to operate in such a way that photons incident on it cause electron-hole pairs to be formed; a connector element connected to the back gate of the quantum dot graphene field effect transistor; a switching element configured to function as an output switch to provide an output for a current flowing through the quantum dot graphene field effect transistor; wherein the quantum dot graphene field effect transistor is configured to be polarized via the connector element connected to the back gate such that the electrons or holes formed are trapped in at least one quantum dot and, respectively, the holes or electrons migrate to the field-effect quantum transistor channel of graphene quantum dots; and wherein a drain to voltage source connected to the graphene quantum dot field effect transistor causes a current proportional to the charge of the holes or electrons trapped in the quantum dots by the electrons or holes to flow in the channel.

PROBLEM TO BE SOLVED

The method of preparing electronic devices formed by (or containing) one-dimensional or two-dimensional structures that present quantum conductance and capacitance with a period of time and a dynamic rate of transfer and transport of electrons correlated by quantum entanglement or interlacing with the quantum capacitive energy states of these structures and which are characteristic of the energy levels of one-dimensional or two-dimensional electronic structures, allows the preparation of advantageous microdevices for various applications.

Such structures may contain one or more quantized energy states composed of specific values of quantum conductance and capacitance. This correlation between the quantum states of conductivity and capacitance is due to a quantum entanglement effect between the state of conductance and capacitance whose ratio is a frequency and its inverse a time characteristic of the state of one-dimensional or two-dimensional materials, both states of conductance and quantized capacitance enable the application of this phenomenon in quantum devices, such as alternating current (A.C.) transistors or transient transistors, when the disturbance is not harmonic.

The properties of A.C. quantum transistors or transients designed based on this type of quantum entanglement phenomenon can be modulated by temporal transient methods or by harmonic perturbations on these one-dimensional or two-dimensional structures and their quantized energy states. An example of harmonic temporal perturbation of these entangled quantum structures is the experimental perturbation that makes use of impedance spectroscopy and its derivations, but this is not the only technique or method that allows access to this type of quantized information in one- or two-dimensional structures, but It is certainly one of the most versatile and powerful.

Thus, the present invention deals with a method of obtaining, as well as the transistors obtained that operate in A.C. mode with the advantages of also being able to operate in an electrochemical environment when necessary, and which use quantum entanglement states formed by the correlation of signals between conduction states (quantum conductance) and energy storage (quantum capacitance), both quantized states, of 1D or 2D materials deposited on a substrate or connected between two conductive terminals, with great advantages in their use.

DESCRIPTION OF FIGURES

To complement the present description to obtain a better understanding of the characteristics of the present invention and its potential for use as A.C. transistors and in accordance with a preferred practical implementation of the same, the attached description is accompanied by a set of figures, where, in an exemplified, although not limiting, manner, the following were represented:

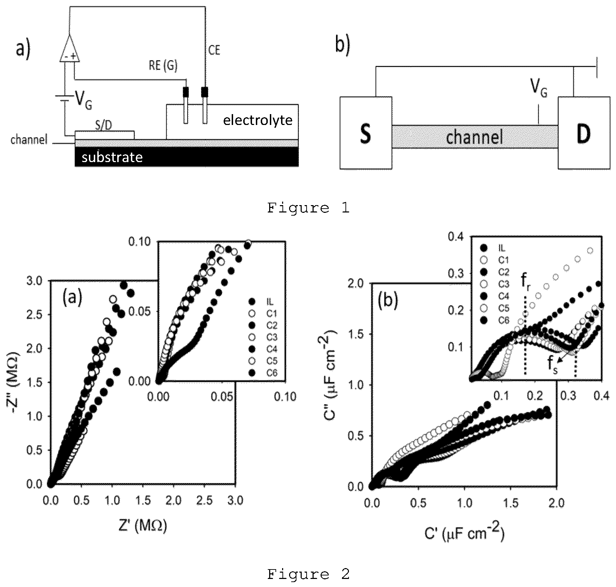

Figure 1 illustrates: in (a) a typical architecture of an electrochemical field effect transistor, wherein only a conductive terminal is considered, which acts as source and drain, the reference electrode corresponds to the gate and the 1D or 2D structure corresponds to the channel. In this configuration the transistor operates in A.C. mode and can be monitored by time- or frequency-dependent measures. The electrolyte acts as a dielectric; and (b) corresponds to a configuration of a classical field effect transistor in which the electron density in the channel between the two distinct conductive terminals (S and D) changes according to the change in the gate voltage. The classical transistor operates based on the D.C. voltage response.

Figure 2 illustrates: (a) an impedimetric Nyquist diagram of an electrode containing the 2D material at a given potential; and in (b) a capacitive Nyquist diagram identifying the resonance frequency of the quantum state at the maximum point of the semicircle ($f_r$) and the frequency at the maximum of the capacitance extracted from the diameter of the semicircle ($f_s$). Pure ionic liquid in different concentrations was used as electrolyte.

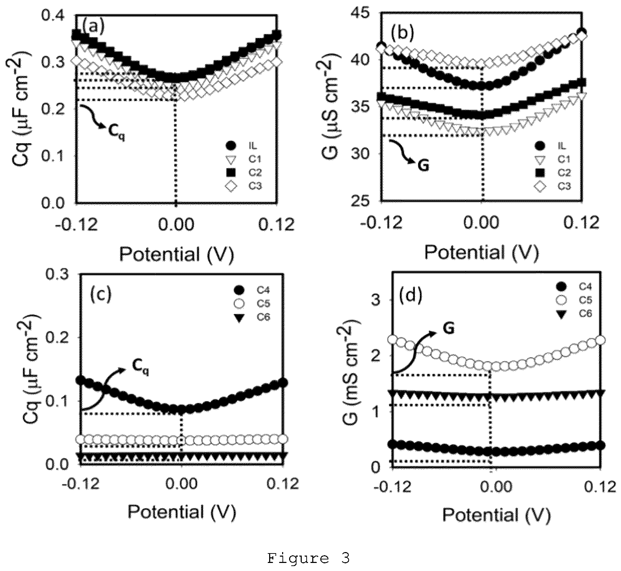

Figure 3 illustrates: (a) the measurement of quantum capacitance in ionic liquid (IL), C1, C2 and C3; in (b) the measurement of conductance in ionic liquid (IL), C1, C2 and C3; in (c) the measurement of the quantum capacitance in C4, C5 and C6; and in (d) the measurement of conductance at C4, C5 and C6 of an electrode containing the 2D material from the corresponding frequency of $C_q$ in a given potential range. Pure ionic liquid in different concentrations was used as electrolyte.

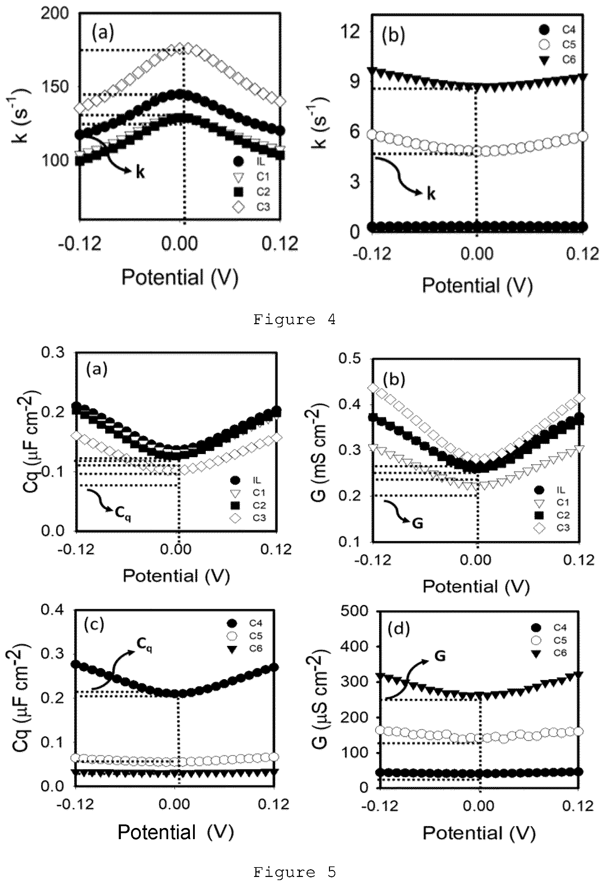

Figure 4 illustrates: (a) the 'rate' or electron transfer ratio k in ionic liquid (IL), C1, C2 and C3 of the electrode; and (b) the rate k in C4, C5 and C6 containing the 2D material from the $C_q$ corresponding frequency in a given potential range.

Figure 5 illustrates: (a) the measurement of quantum capacitance in ionic liquid (IL), C1, C2 and C3; (b) the measurement of conductance in ionic liquid (IL), C1, C2 and C3; (c) the measurement of the quantum capacitance in C4, C5 and C6; and (d) the measurement of the conductance at C4, C5 and C6 of an electrode containing the 2D material from the resonance frequency that corresponds to the maximum point of the semicircle in a given potential range. Pure ionic liquid in different concentrations was used as electrolyte.

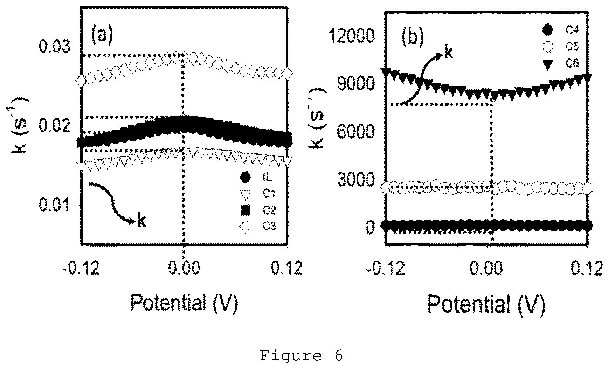

Figure 6 illustrates: (a) the 'rate' or electron transfer ratio k in ionic liquid (IL), C1, C2 and C3 of the electrode; and (b) the rate k in C4, C5 and C6 containing the 2D material from the resonance frequency that corresponds to the maximum point of the semicircle in a given potential range. Pure ionic liquid in different concentrations was used as electrolyte.

GENERAL DESCRIPTION OF THE INVENTION

Quantum entanglement is a physical phenomenon in which the quantum states of various subsystems cannot be described independently of each other, although they are spatially separated. Such a phenomenon offers unique insights into the fundamental principles of our physical world and, at the same time, provides the basis for new communication and sensing protocols that go beyond the capabilities of their classical counterparts. Among the main applications, information processing tasks, Einstein-Podolsky-Rosen paradox, quantum cryptography, superdense coding, information teleportation, quantum computing, entanglement-assisted error correction (and as a tomographic resource) stand out. Large-scale production is still a challenge, however, the success of solid-state devices in the microelectronics revolution has motivated scientists and engineers to design devices based on 1D and 2D materials, which, unlike their classical analogues, have specific quantum properties that differ from the latter.

Structures with nanometric dimensions molded into one-dimensional or two-dimensional materials have excellent electronic, chemical, optical and magnetic properties. Among the one-dimensional materials we mainly have carbon nanotubes, both single-walled and multi-walled, and among the two-dimensional materials the following stand out: graphene, hexagonal boron nitride (hBN), transition metal dichalcogenides (TMDCs), phosphorene, layers of double hydroxides (LDHs), a family of monoelemental compounds (Xenes), metal nitrides/carbides (MXenes), perovskite-type oxides, 2D polymers, etc. Such materials have been used as building blocks for the development of quantum devices.

Devices applying alternating A.C. and transient current have advantages when compared to direct current D.C. devices, as they can operate under a relatively low electric field, which is useful for increasing the efficiency of information and energy emission, reducing energy consumption and improving device stability. Impedance spectroscopy is a non-destructive technique that uses an A.C. signal to excite or perturb a system by measuring the alternating current or voltage response.

One of the most important reasons for working with sinusoidal A.C. current is that it corresponds to the voltage used throughout the world for the transmission of energy and the transmission of information and, by this means, signal transmission between quantum entangled states can also be optimized. Therefore, and due to the above-mentioned advantages, alternating current engineering is relevant in device manufacturing, especially quantum electronic devices. Within this context, impedance spectroscopy and its derivations are versatile and powerful tools and have already proven to be useful for evaluating the characteristics of a molecular circuit at electrochemical interfaces and in analytical systems.

Due to this, the present invention of method and transistors operating in A.C. mode (with the advantages of also being able to operate in an electrochemical environment when necessary) uses quantum entanglement states formed by the correlation of signals between conduction states (conductance quantum) and energy storage (quantum capacitance), both quantized states, of 1D or 2D materials deposited on a substrate or connected between two conductive terminals.

One-dimensional (1D) and two-dimensional (2D) structures can present both quantum conductance and capacitance according to a period of time and temporal rate characteristic of each quantum state of these structures. This behavior is correlated with the quantum entanglement (or entanglement) of this quantum state; typical of the values and the ratio of the values between conductance and quantum capacitance of $C_q$ this state. This entanglement corresponds to a quantum mechanical phenomenon whose properties in 1D and 2D structures allow the engineering of quantum transistors that operate in AC mode (alternating current) or through transient disturbances. These quantum transistors allow all the applications already available in classical transistors that operate in DC (direct current) mode, but with additional advantages that include greater sensitivities and better electronic and information transport performance over long distances in the device, intrinsic to quantum phenomena and new transistor architectures that were previously not possible to be realized in DC mode, as has been the case with classical transistors.

Quantum capacitance $C_q$ is proportional to the density of states of the quantum state. The entangled state occurs by the quantum entanglement of this quantum capacitance with the quantum conductance G which, in turn, occurs in steps of $e^2/h$ and is maximum for metallic channels of one dimension.

The state of quantum entanglement defines a temporal rate of the quantum state that is given by the ratio $k = G/C_q$, or it defines a characteristic period of time such that $R_q C_q$, being $R_q = 1/G$. $k$ has a frequency unit, i.e., in Hertz, and can also be expressed as a time constant wherein $R_q C_q$ with unit in seconds. Components $G$ and $C_q$ are quantized properties of the electronic structure of 1D and 2D materials and are quantum entangled, in such a way that $k$ or $R_q C_q$ allow us to identify the changes that occur in the system by measuring and monitoring this quantized property.

The quantum and entangled temporal state must be accessed by alternating current (A.C.) measurements or transient measurements, since under these conditions the quantum state remains quantized regardless of the electronic transport mode associated with R or $G$. In the direct current (D.C.) regime, the quantum channel associated with the state of conduction or quantum resistance requires that it function perfectly or have a ballistic mode of transmission. This does not apply to A.C. or transient measurements performed on quantum entangled systems. In A.C. measurements or transients in quantum entangled systems, transport will occur in a quantized manner regardless of the transmission mode of the quantum conduction channel.

1D structures are one-dimensional structured materials that are nanoscale in one dimension. Electrons are confined to one dimension, meaning they cannot move freely. As an example of these structures, we have single-walled carbon nanotubes, multi-walled carbon nanotubes, graphene nanoribbons, inorganic semiconductor nanowires (Group IV - Si and Ge nanowires, Group III-V InAs, GaAs, GaN nanowires, from Group II-VI CdS, CdSe, ZnSe and metal oxide nanowires, such as ZnO and $SnO_2$);

Two-dimensional (2D) materials are scaled to the nanoscale in two dimensions. Electrons are confined in two dimensions, indicating that electrons cannot move freely but only within the 2D plane. As an example of these structures we have graphene and its derivatives (graphene obtained by chemical vapor deposition, epitaxial graphene grown on silicon carbide substrates, graphene obtained by mechanical exfoliation, graphene oxide and reduced graphene oxide obtained by the Hummers method, *crumpled* graphene, graphene nanoribbons); graphene doped with nitrogen, phosphorus, sulfur, oxygen, boron, in addition to atoms belonging to the group of alkali metals and the group of halogens, etc.; nanocomposites formed by graphene/metallic nanoparticles, graphene/conducting polymers, graphene/carbon nanotubes. 2D materials *beyond* graphene (black phosphorus, $MoS_2$, $WSe_2$ h-BN, $CrS_2$, $CrO_2$, $VS_2$, $VO_2$, $NbSe_2$); hexagonal boron nitride and its nanocomposites with metallic nanoparticles, polymers, carbon nanomaterials (graphene and nanotubes), among others.

1D or 2D materials can be deposited on silicon substrates, $Si/SiO_2$, gold, germanium, glassy carbon, indium tin oxide (ITO), tin oxide doped with fluorine (FTO), PET (polyethylene terephthalate) substrates, kapton, parylene-c, glass, *corning.* The electrical contact on the 1D or 2D materials deposited on the substrates can be titanium/gold, titanium/-platinum, chromium/gold, platinum, pure silver, silver/tin, silver/nickel, and other types of silver, silver/oxide of cadmium, silver/tin oxide, tungsten/silver, tungsten/copper, phosphor activation in epitaxial Si, Ge, $Ge_{1-x}Sn_x$, $Si_yGe_{1-x-y}Sn_x$.

Quantum entanglement is accessed through time-dependent and/or transient measurements (A.C. mode being a specific type). The values of the components $G$ and $C_q$ that make up the entanglement (in the case of harmonic electrical measurements of the A.C. type) can be obtained preferably, but not only that way. From the graphs of impedimetric Nyquist (Z' versus -Z'') and capacitive Nyquist (C' versus C'') and impedimetric (Z' or Z'' versus logarithm of the frequency) and capacitive (C' or C'' versus logarithm of frequency) Bode, data corresponding to the components of quantum entanglement are obtained. Z' and Z'' correspond, respectively, to the real component and imaginary component of the complex impedance function. Similarly, C' corresponds to the real component and C'' corresponds to the imaginary component, wherein the real component is related to the imaginary part of the impedance $C' = Z''/\omega|Z|^2$ and the imaginary capacitive component to the real part of the impedance $C'' = Z'/\omega|Z|^2$. The measured complex impedance function $Z^*(\omega)$ can be converted into the complex capacitance function $C^*(\omega)$ by the relation $C^*(\omega) = 1/j\omega Z^*(\omega)$, $j = \sqrt{-1}$ and $\omega$ corresponds to the angular frequency which is given by $\omega = 2\pi f$, where $f$ is the frequency.

The frequency peak of the capacitive Bode plot of the imaginary component corresponds to the resonance frequency or the value of k. This rate is associated with the electrodynamics of the quantum entangled state between the conductance G and the capacitance $C_q$ of the state. $k = G/C_q$.

The capacitance value (real component) at a specific angular frequency of the capacitive Nyquist plot corresponds to $C_q$ of the entangled state whenever $C_q$ dominates the electrochemical equivalent capacitance response of the state. The frequency can be monitored in different media and analyzed against a potential range, in order to obtain the $C_q$ corresponding frequency depending on the potential.

The value of the capacitance (imaginary component at a typical frequency of the process) multiplied by the characteristic angular frequency obtained in the capacitive Nyquist plot corresponds to the quantum conductance G of the entangled state. The frequency can be monitored in different media and analyzed against a potential range, in order to obtain the G corresponding frequency depending on the potential.

Any type of mathematical or circuit adjustment that allows obtaining the values of the conduction and quantum capacitance components.

The change in quantum entanglement occurs due to:
Variation of temporal quantized states of energy depending on the concentration of species present in the medium connected to the *gate* or channel of the A.C. or transient transistor; or the:

Variation of quantized states according to the physical-chemical characteristics of the medium that is in contact with the *gate* or channel of the A.C. transistor or transient; or:

The variation of temporal quantized states of energy depending on an intensity of photons that arrive at the *gate* or channel of the A.C. transistor or transient; or:

The variation of temporal quantized states of energy depending on an intensity of electromagnetic radiation that reaches the *gate* or channel of the A.C. transistor or transient; or:

The variation of temporal quantized states of energy as a function of a temperature variation at the *gate* or channel of the A.C. transistor or transient, or:

The variation of temporal quantized states of energy as a function of a varied mass at the *gate* or channel of the A.C. transistor or transient; or:

The variation of temporal quantized states of energy as a function of a variation in the electric or magnetic field in the A.C. transistor channel or transient.

The change in quantum entanglement can also occur due to the physical or chemical modification of the *gate* with electroactive or non-electroactive molecules.

Some time-dependent and transient measurement techniques include Square wave voltammetry (SWV); differential pulse voltammetry (DPV); impedance spectroscopy (electrical and electrochemical, EIE). In the case of EIE, it also involves its derivations such as capacitance spectroscopy (electrical and electrochemical), as well as other immittance functions (electrical and electrochemical).

Transistors obtained using alternating current (A.C. mode of operation) are characterized by being economically viable and with better electronic transport performance in the transistor channel, offering less energy loss during operation. Transistors are characterized by acting as amplifiers or switches and can be employed in basic components of all electronic chips and new quantum transistor devices, as long as they use A. C. modes or similar modulation of operation. The transistors obtained can be used as field effect transistors, bipolar junction transistors, small signal transistors, switching transistors, power transistors, photo transistors, among others.

The transistors obtained may be field effect transistors (FET) of different natures, such as: depletion type metal-oxide-semiconductor FET (MOSFET) which may be N-channel or P-channel, as well of intensification type which may be N-channel or P-channel, depletion type FET (JFET) junction which can be N-channel or P-channel, organic field effect transistor (OGFET), insulated gate bipolar transistor (IGBT), organic memory nanoparticle (NOMFET), DNA field-effect *transistor* (DNAFET), metal-semiconductor field-effect transistor (MESFET), high electron mobility transistor (HEMT), fast recovery epitaxial diodes (FREDFET), sensitive field-effect transistor ion transistor (ISFET), chemically sensitive field effect transistor (ChemFET), graphene-based field effect transistor (GFET).

For quantum entanglement to be used, the channel must be made of materials with 1D or 2D dimensions and the transistor must operate in AC or transient regimes with entangled states between conductance and capacitance.

The phenomenon of quantum entanglement is characterized by the possibility of being used in optical communication, emerging technologies of quantum computing and quantum cryptography, quantum teleportation (quantum networks and quantum calculations), quantum information science, sensing, multiplexable devices, metrology, improved microscopes, quantum biology (biological compass), such that:

Pulsed optical communication adjusts transistor frequencies promoting space-based communications, such as satellite to satellite and space vehicle to space vehicle (including HAPs, *high-altitude platform-station),* which may eventually be ideal for application of server-to-server and router-to-router for Internet connectivity;

The quantum computer can use quantum bits, or qubits, which in turn encode zero and one into two distinguishable quantum states. Where quantum cryptography allows completely secure communications between distant parties and quantum entanglement of states can be differentiating for this type of technology;

Quantum teleportation can transmit information in quantum networks (in the specific case mentioned here, it may occur due to the use of quantum entanglement) and can serve as an elementary operation in quantum computers. Entangled transistor systems can also be a differentiator in this type of technology;

Quantum information science, using the property of entanglement and 1D and 2D structures can study the smallest particles of matter and energy such as fermions, to obtain and process information in ways that cannot be achieved based on the principles of classical physics. This category encompasses metrology, sensing, communication, computing and quantum simulation;

Quantum metrology and sensing using the entanglement property can provide greater precision compared to products based on classical physics or existing quantum technologies. They include atomic clocks, gravitational gravimeters and gradiometers, inertial motion units, atomic magnetometers, magnetoencephalography scanners, electron microscopes, quantum-assisted nuclear rotary imaging devices, Global Position System (GPS) systems, gas concentration sensors, among others;

Quantum computing and simulation, using the property of entanglement and 1D and 2D structures can offer the possibility of computing in an exponentially greater way regarding the spacing between states than could be accessible with classical computing and allow the use of quantum hardware to undertake the critical properties of a complex quantum system;

Quantum biosensors, using the property of entanglement and 1D and 2D structures, can be much more sensitive and precise than what is currently available for applications in health field (diagnosis of diseases, discoveries of new compounds), environment (detection of pesticides, chemical weapons, contaminants in water, ecological pollution control), food industry (detection of bacteria, chemical and biological contaminants, quality control). Detection of the analyte may require the modification of 1D and 2D materials with receptors;

Quantum biosensors, using the property of entanglement and 1D and 2D structures, can be optical, electrochemical, colorimetric, piezoelectric, magnetic whenever based on the quantum entanglement phenomenon of an A.C. or transient transistor. The biosensor can qualitatively or quantitatively recognize an analyte. Quantum biosensors can be multiplexable devices that are characterized by detecting more than one analyte. Biosensors can be *point-of-care* devices that are characterized by being portable and allowing quick and real-time diagnostic tests;

The receptor anchored in 1D and 2D materials can be based on aptamers, antibodies, antigens, antibody fragments, oligosaccharides, peptides, cells, bacteria, viral particles, enzymes and proteins; and

The analyte recognized by the receptor can be aptamers, antibodies, antigens, antibody fragments, oligosaccharides, peptides, cells, bacteria, viral particles, enzymes and proteins;

DETAILED DESCRIPTION AND EXAMPLE OF IMPLEMENTATION OF THE INVENTION

The present invention deals with a method of obtaining transistors operating in A.C. mode with the advantages of also being able to operate in an electrochemical environment when necessary and which uses states of quantum entanglement formed by the correlation of signals between conduction states (conductance quantum) and energy storage (quantum capacitance), both quantized states, of 1D or 2D materials deposited on a substrate or connected between two conductive terminals.

In both cases, these 1D and 2D structures (see Figure 1) form a channel of a transistor with electrodes containing suitable electrical contacts and connected to the external environment and allowing access to the channel's quantum conductance and capacitance states, (as defined in equations 1 and 2 below, respectively) and which operate according to a period of time and a conductance/capacitance ratio (according to equation 3 below) as a characteristic signal, and which vary quantumly in accordance with a variation imposed by the medium in the transistor channel that is in contact with the medium through the terminal called *gate* or door (see below). This entangled quantum state is dependent on the medium in which the transistor is inserted and also allows applications of quantum entanglement such as AC and transient field effect transistors.

The conventional field effect transistor system can be composed of three elements: *'source'* (S), *'drain'* (D) and *'gate'* (G). The *'source'* is the terminal where charge carriers enter the channel, while the *'drain'* is the terminal where the charges leave the channel and *'gate'* is responsible for modulating the conductivity in the *'channel'*. The terminals represent the point at which the transistor is connected to the circuit, and this is made up of conductive materials, such as gold and titanium. In a configuration containing only one conductive terminal, this will act as source and drain. In this example, the one-dimensional or two-dimensional structures deposited on a base substrate will be exposed to the medium and will act as the channel and the reference electrode, which can be platinum, will act as the gate (Figure 1a). In a configuration containing two terminals, which are physically distinguishable from each other, both will be coupled by a conductive connection and, therefore, one will act as a source and the other as a drain (Figure 1b). Both configurations may or may not contain an electrolyte, that is, the medium may be liquid, gaseous or another physical or chemical state of matter.

As an example, we show the variation of the conductive and capacitive components of a transistor operating in electrochemical mode accompanied by two specific frequencies obtained by impedance-derived capacitance spectroscopy measurements: the resonance frequency of the quantum state obtained at the maximum point of the semicircle in the capacitive Nyquist diagram (*fr*, Figure 2b) and the frequency obtained at the maximum of the capacitance, which is extracted from the diameter of the semicircle of the capacitive Nyquist diagram ($f_s$, Figure 2b) at each concentration. Frequency variation is observed when changing the salt concentration in the ionic (dielectric) liquid. With the increase in ionic concentration, which is in contact with the 1D or 2D structure and contains quantized energy levels, a change in the external potential is observed that affects the quantum channel, which in turn responds in an entangled way, that is, there is an interdependence in the responses of capacitive ($C_q$) and conductive (G) properties.

Both frequencies can be used as parameters for monitoring the entangled quantum state due to changes imposed on the medium (gate or changes in the transistor channel). It was observed that the changes occur in an entangled and quantized way, demonstrating the application of the operating principles of the A.C. transistor in monitoring the environment in which it is in contact.

According to the present invention, proof of the feasibility of using electrodes manufactured as one-dimensional (1D) or two-dimensional (2D) structures such as A.C. transistors, comprises, for example, a 2D carbon-based structure with quantized states that is deposited in a controlled manner on a base, non-conductive and flat substrate and then an ohmic electrical contact suitable for carrying out the measurements is deposited, which are carried out in electrochemical mode. For these measurements, a potential is applied to the contacts and the 2D structure acts as a working electrode; Platinum is used as a counter electrode and quasi-reference.

As illustrated in Figure 1a, in the present invention the electrochemical field effect transistor consists of a terminal acting as source and drain (it could have a configuration containing two terminals as shown in Figure 2b), the platinum electrode as gate and the 2D structure the channel. The electrolyte used is an ionic liquid (which acts as a dielectric in the transistor configuration) and to this dielectric or ionic liquid quantities of salt are added in 6 (six) different concentrations in order to change the ionic concentration of the medium and its properties. Such changes implied a change in the electric field in the A.C. transistor channel and consequently caused a quantized change in the response, as can be seen by the discontinuous change in conductance G and quantum capacitance $C_q$ as indicated in Figures 3 and 5.

The change occurs in an entangled way between the conductance and the quantum capacitance in the A.C. transistor channel, and this can be observed when analyzing the ratio in $G/C_q$ that corresponds to a temporal rate of electronic transfer (Figures 4 and 6), as can be seen from the theory presented below. The impedance spectroscopy measurements that were used to obtain $G$ e $C_q$ were carried out using a potentiostat equipped with a frequency response analyzer (Figure 2a).

Impedance-derived capacitance spectroscopy diagrams (Figure 2b) were acquired over a wide frequency range, with a 10 mV sinusoidal perturbation at the open circuit potential. The measured complex impedance function $Z^*(\omega)$ was converted into the complex capacitance function $C^*(\omega)$ by the relation $C^*(\omega) = 1/j\omega Z^*(\omega)$, where $\omega$ is the angular frequency and $j = \sqrt{-1}$ . Thus, the real and imaginary components of the capacitance are accessed as $C' = Z''/\omega|Z|^2$ and $C'' = Z'/\omega|Z|^2$, where $|Z| = \sqrt{Z'^2 + Z''^2}$ is the module of the complex impedance function.

To obtain impedance-derived capacitance spectroscopy, initially impedance spectroscopy measurements are performed at a fixed potential, as can be seen in the Nyquist diagram present in Figure 2a. The impedance spectroscopy data is converted into complex capacitance data, shown in Figure 2b. The $f_r$ and $f_s$ frequencies were extracted from the capacitive Nyquist plot, identified in Figure 2b. Both frequencies were obtained against the variation imposed by the environment, and then analyzed against a potential range.

Electrochemical capacitance, in turn, is defined as:

$$\frac{1}{c_\mu} = \frac{1}{c_e} + \frac{1}{c_q} \qquad\qquad \texttt{(formula 1)}$$

wherein $C_\mu$ is the electrochemical capacitance (equivalent capacitance), $C_e$ corresponds to geometric or electrostatic capacitance and $C_q$ is the quantum capacitance. Like $C_e \gg C_q$ for quantized 1D and 2D structures, $C_\mu \sim C_q$. In other words, in cases where there is a significant density of electrons in accessible states in the nanostructure, as in the case of the present system based on graphene whose electronic structure is formed by carbon atoms arranged two-dimensionally, $C_\mu$ is dominated by $C_q$ and, consequently, electric field screening is governed by electron dynamics attenuated by the electrochemical environment that relates to the quantum phenomena associated with $C_q$.

Both frequencies were evaluated at different ionic concentrations. Figures 3a and 3c correspond to $C_q$ of the system and Figures 3b and 3d correspond to the conductance G for the frequency at maximum capacitance, at lower and higher ionic concentrations, respectively. Figures 5a and 5c correspond to the $C_q$ measurement of the 2D system and Figures 5b and 5d correspond to $G$ at the resonance frequency, at lower and higher ionic concentrations, respectively.

Conductance $G(\mu)$ is related to the electron transfer/transport process and is described by:

$$G(\mu) = \left(\frac{2e^2}{h}\right) \sum_n T_n(\mu) = G_0 \sum_n T_n(\mu) \qquad\qquad \texttt{(formula 2)}$$

where $G_0 = 2e^2/h$ is the quantum conductance and $\Sigma_n T_n(\mu)$ is the electron transmission probability matrix in a quantum channel for the transport of electrons in this channel at a given chemical potential $\mu$. In an ideal quantum channel, the transmission matrix is equivalent to one unit, and in this case, $G(\mu)$ it is equal to $G_0$. The channels represent the communication probabilities between quantized energy states that exchange electrons with each other and the electron transmittance depends on the physical characteristics of the scattering region.

However, it is important to highlight that the electronic transport associated with $G(\mu)$ when measured in A.C. or transient mode remains quantized regardless of the electron transmission mode during electronic transport. In the classical case and in direct current mode, D.C., although universal, is only quantized if there is a perfect channel transmittance or ballistics.

This correlation between conductance and quantum capacitance has already been observed in the transfer of electrons at the nanometric scale of molecular films and can be characterized by a "rate" or electron transfer ratio k that is expressed by the ratio between the functions G and $C_\mu$ in such a way that:

$$k(\mu) = \frac{2e^2}{h} \sum_n T_n(\mu) \left( \frac{1}{c_e} + \frac{1}{c_q} \right) = \frac{G(\mu)}{C_\mu(\mu)} \qquad \text{(formula 3)}$$

For the present case $C_e \gg C_q$ and therefore $k$ for the 2D system corresponds to $k = G/C_q$. Figures 4a and 4b and Figures 6a and 6b correspond to an electron transfer rate $k = G/C_q$ that is determined by the relationship between quantum capacitance (energy storage) and quantum conductance (charge transport) within the 2D carbon-based structure. Note that k is a temporal unit of frequency measured in $s^{-1}$ (1/seconds or equivalent to Hertz) and can also be interpreted as a period of time constant in which G = 11R offers $k^{-1} = \tau = R_q C_q$, and therefore in a way that it is possible to characterize a quantum entangled state and a temporal energy state as a function of different ionic concentrations of the electrolyte present in the medium. As $G$ and $C_q$ are quantized and are quantum entangled, k obtained for the 1D or 2D structure is also quantized and is an intrinsic temporal property of the 1D or 2D system that can be used as a quantum channel in a transistor, in the electrochemical case, and which, due to its entanglement nature, allows the transmission of energy and information over long distances and is extremely sensitive to changes in the chemical environment coupled to the quantum channel and its temporal energy level.

That way, we can observe the correlation of the capacitance $C_q$ and quantum conductance G of the 2D structure according to the variation of the ionic strength in the ionic liquid that is in contact with the 2D structure and imposes an electric field on the quantum channel that responds in a quantized way. It is observed that any change between its components affects the quantized charge balance, due to the quantum coupling effect between them, and can then be monitored by time or frequency dependent measurements, as is the case with impedance spectroscopy, among others, demonstrating that changes occur in leaps and not continuously. This correlation between quantum conductivity and capacitance is directly related to quantum entanglement in such a way that it allows the application of this phenomenon as AC transistors and transients and any modification imposed in a spatial region of the material can be felt in both the capacitance and conductance, in different regions of the material.

The ratio between conductance and capacitance is exemplified, which is physically described through electronic transfer defined as $k = G/C_q$, as a quantized property, as are the individual elements of conductance and capacitance of the structure, with changes occurring in leaps and not continuously, thus exemplifying the high quantization of the system. The use of these properties has an important impact on the design of A.C. or transient transistors that are intrinsically temporal, unlike their classical analogues that operate in D.C. and continuous mode, intrinsically independent of time.

It is evident that when the present invention is put into practice, modifications may be introduced regarding certain details, without departing from the fundamental principles that are clearly substantiated in the claims, thus understanding that the terminology used should not represent a limitation.

Thus, from the configuration and functioning characteristics described above, it can be clearly noted that the QUANTUM TRANSISTOR AND QUANTUM MODIFIED TRANSISTOR PREPARATION METHOD are a new method and device for the State of the Art, which has unprecedented conditions of innovation, inventive activity and industrialization, which make it deserve the Invention Patent Privilege.

**Claims**

1. **QUANTUM TRANSISTOR PREPARATION METHOD, _characterized in_ that** it comprises one-dimensional (1D) and two-dimensional (2D) structures that exhibit quantum conductance G and capacitance $C_q$ behavior according to a period of time and temporal rate of each quantum state of such structures correlated with quantum entanglement (or interlacing) of this quantum state; wherein the components $G$ and $C_q$ are quantized properties of the electronic structure of 1D and 2D materials, which are quantum entangled; wherein the electrons are confined to one dimension when in one-dimensional (1D) structures, and wherein the electrons are confined to one or two dimensions when in two-dimensional (2D) structures, thus indicating that electrons can move freely with speeds around the Fermi speed only within the 1D and 2D plane, respectively; these structures can configure transistors that are modified by quantum engineering working in A.C. (alternating current) mode or by transient disturbances with entangled states between conductance and capacitance.

2. **METHOD,** according to claim 1, **_characterized in_ that** the quantum capacitance $C_q$ is proportional to the density of quantum states; and the entangled state occurs due to the quantum interlacing of the quantum capacitance with the quantum conductance $G$ which, in turn, occurs in steps of $e^2/h$ and is maximum for metallic channels of one dimension.

3. **METHOD,** according to claim 1, ***characterized in*** **that** the quantum and entangled temporal state is accessed by alternating current (A.C.) measurements or transient measurements since the transport occurs in a quantized way regardless of the transmission mode of the quantum conduction channel.

4. **METHOD,** according to claim 1, ***characterized in*** **that** the materials with one-dimensional (1D) structures comprise single-walled carbon nanotubes, multi-walled carbon nanotubes, graphene nanoribbons, Group IV inorganic semiconductor nanowires - Si and Ge nanowires, Group III-V InAs nanowires, GaAs, GaN, Group II-VI CdS nanowires, CdSe, ZnSe and metal oxide nanowires such as ZnO and $SnO_2$.

5. **METHOD,** according to claim 1, ***characterized in*** **that** the materials with two-dimensional (2D) structures comprise graphene and its derivatives: graphene obtained by chemical vapor deposition, epitaxial graphene grown on substrates of silicon carbide, graphene obtained by mechanical exfoliation, graphene oxide and reduced graphene oxide obtained by Hummers method, *crumpled* graphene, graphene nanoribbons; graphene doped with nitrogen, phosphorus, sulfur, oxygen, boron, in addition to atoms belonging to the alkali metal group and the halogen group, and others; nanocomposites formed by graphene/metallic nanoparticles, graphene/conducting polymers, graphene/-carbon nanotubes; 2D materials *beyond* graphene, black phosphorus, $MoS_2$, $WSe_2$ h-BN, $CrS_2$, $CrO_2$, $VS_2$, $VO_2$, $NbSe_2$; hexagonal boron nitride and its nanocomposites with metallic nanoparticles, polymers, carbon nanomaterials (graphene and nanotubes), among others.

6. **METHOD,** according to claim 1, ***characterized in*** **that** the materials of one-dimensional structures (1D) and two-dimensional structures (2D) are deposited on substrates of silicon, $Si/SiO_2$, gold, germanium, glassy carbon, indium and tin oxide (ITO), fluorine-doped tin oxide (FTO), PET (polyethylene terephthalate) substrates, kapton, parylene-c, glass, *corning.*

7. **METHOD,** according to claim 1, ***characterized in*** **that** quantum entanglement is accessed through time-dependent and/or transient measurements; wherein the values of the components G and $C_q$ can be obtained preferably, but not only by: from the graphs of impedimetric Nyquist (Z' versus -Z'') and capacitive Nyquist (C' versus C") and impedimetric Bode (Z' or Z'' versus logarithm of the frequency) and capacitive (C' or C" versus logarithm of frequency); by the frequency peak of the capacitive Bode plot of the imaginary component; by the capacitance value (real component) at a specific angular frequency from the capacitive Nyquist plot; by the frequency monitored in different media and analyzed against a potential range; by the capacitance value multiplied by the characteristic angular frequency obtained from the capacitive Nyquist plot; by the frequency monitored in different media and analyzed against a potential range, in order to obtain the corresponding G as a function of the potential; and by any type of mathematical or circuit adjustment that allows obtaining the values of the conduction and quantum capacitance components.

8. **METHOD,** according to claim 1, ***characterized in*** **that** the change in quantum entanglement occurs due to: variation of temporal quantized states of energy as a function of the concentration of species present in the medium connected to the gate or channel of A.C. transistor or transient; variation of quantized states according to the physical-chemical characteristics of the medium that is in contact with the gate or channel of A.C. transistor or transient; variation of temporal quantized states of energy as a function of an intensity of photons that arrive at the gate or channel of A.C. transistor or transient; variation of temporal quantized states of energy depending on an intensity of electromagnetic radiation that reaches the gate or channel of A.C. transistor or transient; variation of temporal quantized states of energy as a function of a temperature variation at the gate or channel of A.C. transistor or transient; variation of temporal quantized states of energy as a function of a varied mass at the gate or channel of A.C. transistor or transient; and variation of the temporal quantized states of energy as a function of a variation in the electric or magnetic field in A.C. transistor channel or transient.

9. **QUANTUM MODIFIED TRANSISTOR,** ***characterized in*** **that** it comprises one-dimensional (1D) and two-dimensional (2D) structures that exhibit quantum conductance *G* and capacitance $C_q$ behavior according to a period of time and temporal rate of each quantum state of these structures correlated with entanglement (or interlacing) quantum of this quantum state; deposited or connected between two conductive terminals; wherein the components G and $C_q$ are quantized properties of the electronic structure of 1D and 2D materials and are quantum entangled; wherein one-dimensional (1D) structures electrons are confined in one dimension and two-dimensional (2D) structures electrons are confined in two dimensions, indicating that electrons cannot move freely, but only within the 1D and 2D plane, respectively; whereind said structures define the channel and configure the quantum transistor working in A.C. (alternating current) mode or by transient disturbances with entangled states between conductance and capacitance.

10. **TRANSISTOR,** according to claim 9, _**characterized in**_ **that** the substrate may be silicon, $Si/SiO_2$, gold, germanium, glassy carbon, indium tin oxide (ITO), fluorine-doped tin oxide (FTO), substrates of PET (polyethylene terephthalate), kapton, parylene-c, glass, _corning._

11. **TRANSISTOR,** according to claim 9, _**characterized in**_ **that** the channel with the electrodes contains suitable electrical contacts which are connected with the external environment to access the conductance and quantum capacitance states of the channel that operate according to a period of time and a ratio conductance/capacitance as a characteristic signal, and may vary quantumly in accordance with a variation imposed by the medium in the transistor channel that is in contact with the medium through the terminal _gate_ or door; said entangled quantum state is dependent on the medium in which the transistor is inserted, wherein the change in quantum entanglement occurs as a function of the physical or chemical modification of the gate with electroactive molecules or not.

12. **TRANSISTOR,** according to claim 9, _**characterized in**_ **that** quantum entanglement confers property for effect transistors; it can operate in an electrochemical environment when necessary; with field effect (FET), metal-oxide-semiconductor (MOSFET) depletion type, which can be N-channel or P-channel, and intensification type, which can be N-channel or P-channel, depletion type FET (JFET) junction, which can be N-channel or P-channel, organic field effect transistor (OGFET), insulated gate bipolar transistor (IGBT), organic nanoparticle memory (NOMFET), DNA field effect transistor (DNAFET), semiconductor and metal field effect (MESFET), high electron mobility transistor (HEMT), fast recovery epitaxial diodes (FREDFET), ion sensitive field effect transistor (ISFET), chemically sensitive field effect transistor (ChemFET), and graphene-based field effect transistor (GFET).

13. **TRANSISTOR,** according to claim 9, _**characterized in**_ **that** the materials with one-dimensional (1D) structures comprise single-walled carbon nanotubes, multi-walled carbon nanotubes, graphene nanoribbons, Group IV inorganic semiconductor nanowires - Si nanowires and Ge, Group III-V InAs, GaAs, GaN nanowires, Group II-VI CdS, CdSe, ZnSe nanowires and metal oxide nanowires such as ZnO and $SnO_2$.

14. **TRANSISTOR,** according to claim 9, _**characterized in**_ **that** the materials with two-dimensional (2D) structures comprise graphene and its derivatives: graphene obtained by chemical vapor deposition, epitaxial graphene grown on silicon carbide substrates, graphene obtained by mechanical exfoliation, graphene oxide and reduced graphene oxide obtained by Hummers method, _crumpled_ graphene, graphene nanoribbons; graphene doped with nitrogen, phosphorus, sulfur, oxygen, boron, in addition to atoms belonging to the alkali metal group and the halogen group, and others; nanocomposites formed by graphene/metallic nanoparticles, graphene/conducting polymers, graphene/-carbon nanotubes; 2D materials _beyond_ graphene, black phosphorus, $MoS_2$, $WSe_2$ h-BN, $CrS_2$, $CrO_2$, $VS_2$, $VO_2$, $NbSe_2$; hexagonal boron nitride and its nanocomposites with metallic nanoparticles, polymers, carbon nanomaterials (graphene and nanotubes), among others.

15. **TRANSISTOR,** according to claim 9, _**characterized in**_ **that** the electrical contact on the materials deposited on the substrates can be titanium/gold, titanium/platinum, chromium/gold, platinum, pure silver, silver/tin, silver/nickel, and other types of silver, silver/cadmium oxide, silver/tin oxide, tungsten/silver, tungsten/copper, phosphor activation in epitaxial Si, Ge, $Ge_{1-x}Sn_x$, $Si_yGe_{1-x-y}Sn_x$.

Figure 1

Figure 2

EP 4 465 363 A1

Figure 3

Figure 4

Figure 5

Figure 6

**INTERNATIONAL SEARCH REPORT**

| International application No. |
| --- |
| **PCT/BR2022/050522** |

A.   CLASSIFICATION OF SUBJECT MATTER

   IPC: H01L29/66 (2006.01),  H01L29/778 (2006.01)
   CPC: B82Y10/00 ; H01L 29/66977
According to International Patent Classification (IPC) or to both national classification and IPC

B.   FIELDS SEARCHED

Minimum documentation searched (classification system followed by classification symbols)

   IPC: H01L 29/00;   CPC: B82Y10/00

Documentation searched other than minimum documentation to the extent that such documents are included in the fields searched

   **Base de Patentes - INPI/BR**

Electronic data base consulted during the international search (name of data base and, where practicable, search terms used)

   **Derwent Innovation, Google Patents**

C.   DOCUMENTS CONSIDERED TO BE RELEVANT

| Category* | Citation of document, with indication, where appropriate, of the relevant passages | Relevant to claim No. |
| --- | --- | --- |
| X | US 9773208 B2 (HITACHI LTD [JP])<br>26   Sept   2017 (2017-09-26)<br>[figs.3, 4, 5, 6, 13, 26A e 26B, 33, col.1 56 – 67, col.6 lines 9, 15 – 67, col.10, col.11 lines 40 – 67, col. 12 lines 15 – 57, col.18, col.20 lines 17 – 32] | 9 – 11, 13 – 15 |
| X | US 11171225 B2 (GOVERNING COUNCIL UNIV TORONTO [CA]) 09   Nov   2021 (2021-11-09)<br>[figs.1a & 1b, 36, col.5  lines 50 – 67, col.3  lines  1 – 10, col.8  lines 30 – 40,  col.11 lines 10 – 20, lines 40 – 50] | 9 – 11, 13 – 15 |
| A | US 2019164959 A1 (INTEL CORP [US])<br>30 May  2019 (2019-05-30) | ------- |

| [X]   Further documents are listed in the continuation of Box C. | [X]   See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 3/03/2023 | 15/03/2023 |

| Name and mailing address of the ISA/ | Authorized officer |
| --- | --- |
| INSTITUTO NACIONAL DA PROPRIEDADE INDUSTRIAL<br>Rua Mayrink Veiga nº 9, 6º andar<br>Facsimile No.   cep: 20090-910, Centro - Rio de Janeiro/RJ | Telephone No. |

Form PCT/ISA/210 (second sheet) (January 2015)

**INTERNATIONAL SEARCH REPORT**

International application No.

**PCT/BR2022/050522**

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
   because they relate to subject matter not required to be searched by this Authority, namely:

2. ☒ Claims Nos.: 1-8 and 12
   because they relate to parts of the international application that do not comply with the prescribed requirements to such an extent that no meaningful international search can be carried out, specifically:

   Claims 1-8 relate to a method and claim 12 relates to a device. However, the text of said claims 1-8 does not describe the steps that define the method for producing the quantum transistor; it only provides explanations about the phenomenon or the result achieved. Claim 12 does not describe any structural technical features for the definition of said device; it only provides general explanations about the mode of operation or the use of said device.

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (January 2015)

| INTERNATIONAL SEARCH REPORT | International application No. |
|---|---|
| | PCT/BR2022/050522 |

C (Continuation).    DOCUMENTS CONSIDERED TO BE RELEVANT

| Category* | Citation of document, with indication, where appropriate, of the relevant passages | Relevant to claim No. |
|---|---|---|
| A | US 10822231 B2 (EQUAL1 LABS INC [US])<br>03  Nov   2020 (2020-11-03) | ------- |
| A | US 6710368 B2 (FISHER KEN SCOTT; BAXTER KEVIN COTTON)<br>23 March   2004 (2004-03-23) | ---------- |
| A | S. Ilani et al., "Measurement of the quantum capacitance of interacting electrons in carbon nanotubes", Nature Physics volume 2, pages687–691 (2006), doi:10.1038/nphys412<br>https://www.nature.com/articles/nphys412#article-info | ---------- |
| A | Wyrick, Jonathan et al., "Atom-by-Atom Fabrication of Single and Few Dopant Quantum Devices", Journal Volume: 29; Journal Issue: 52; Journal ID: ISSN 1616-301X, 2019-08-14<br>https://doi.org/10.1002/adfm.201903475 | ---------- |

Form PCT/ISA/210 (continuation of second sheet) (January 2015)

**INTERNATIONAL SEARCH REPORT**

| International application No. |
| --- |
| **PCT/BR2022/050522** |

| Box No. II | Observations where certain claims were found unsearchable (Continuation of item 2 of first sheet) |
| --- | --- |

This international search report has not been established in respect of certain claims under Article 17(2)(a) for the following reasons:

1. ☐ Claims Nos.:
because they relate to subject matter not required to be searched by this Authority, namely:

2. ☒ Claims Nos.:  **1-8 and 12**
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
| --- | --- |

This International Searching Authority found multiple inventions in this international application, as follows:

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (January 2015)

INTERNATIONAL SEARCH REPORT
Information on patent family members

International application No.

**PCT/BR2022/050522**

| | | | |
|---|---|---|---|
| US 9773208 B2 | 2017-09-26 | US 2016300155 A1 | 2016-10-13 |
| | | EP 3082073 A1 | 2016-10-19 |
| US 2019164959 A1 | 2019-05-30 | CN 109643710 A | 2019-04-16 |
| | | WO 2018063206 A1 | 2018-04-05 |
| US 11171225 B2 | 2021-11-09 | US 2020185512 A1 | 2020-06-11 |
| | | US 2022223722 A1 | 2022-07-14 |
| US 10822231 B2 | 2020-11-03 | NONE | |
| US 6710368 B2 | 2004-03-23 | US 2003062560 A1 | 2003-04-03 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0595106 A
- JP H01189968 A

- EP 3073728 A1